# EUROPÄISCHE PATENTSCHRIFT

(11) **EP 1 956 653 B1**
(45) Veröffentlichungstag und Bekanntmachung des Hinweises auf die Patenterteilung: **16.03.2011**
(21) Anmeldenummer: 08100197.6
(22) Anmeldetag: 08.01.2008
(51) Int. Cl.: H01L 25/16, H04R 25/00

(54) **Schaltungsvorrichtung mit gebondetem SMD-Bauteil**
Circuit device with bonded SMD component
Dispositif avec un circuit doté d'un composant SMD relié

(30) Priorität: 06.02.2007 DE 102007005862
(43) Veröffentlichungstag der Anmeldung: 13.08.2008
(73) Patentinhaber: Siemens Audiologische Technik GmbH, 91058 Erlangen (DE)
(72) Erfinder: Chan, Chor Fan, 730659, Singapore (SG); Lim, Meng Kiang, 310060, Singapore (SG)
(74) Vertreter: Maier, Daniel Oliver

(56) Entgegenhaltungen:
- EP-A- 0 575 051
- US-A1- 2003 034 563
- US-A1- 2006 113 677
- US-A1- 2007 023 922

## Beschreibung

Die vorliegende Erfindung betrifft eine Schaltungsvorrichtung insbesondere für eine Hörvorrichtung mit einem SMD-Bauteil und einer weiteren Elektronikkomponente. Unter einer Hörvorrichtung wird hier insbesondere ein Hörgerät, aber auch ein Headset, ein Kopfhörer und dergleichen verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO) und In-dem-Ohr-Hörgeräte (IdO), z.B. auch Concha-Hörgeräte oder Kanal-Hörgeräte (CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

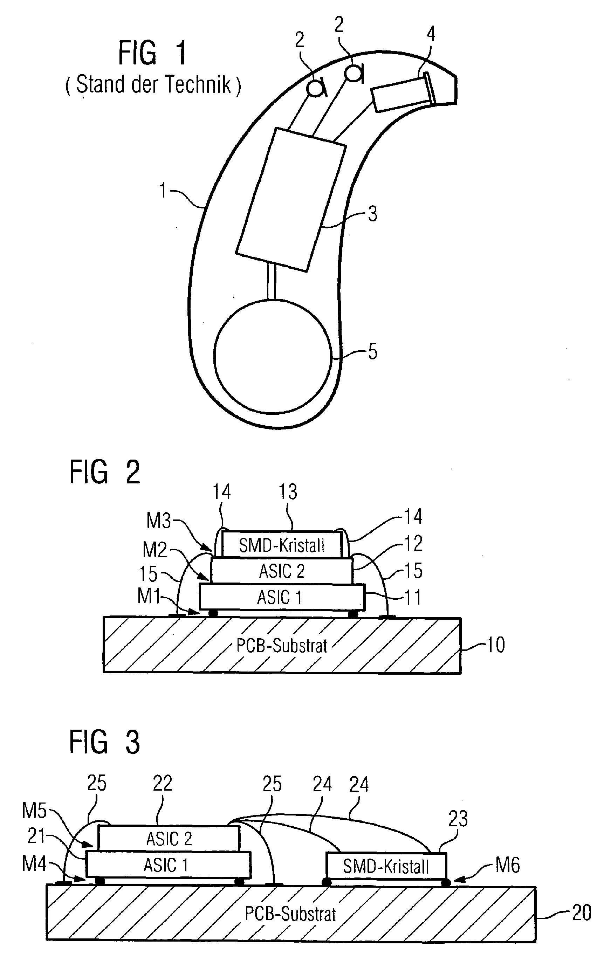

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Grundsätzliches Ziel bei der Weiterentwicklung von Hörgeräten und anderen Hörvorrichtungen ist deren Miniaturisierung. Dies gilt insbesondere auch für die Signalverarbeitungseinheit, die üblicherweise auf einer Leiterplatte (PCB-Substrat) aufgebaut ist. Andererseits sollen immer mehr Funktionen in ein Hörgerät integriert werden, so dass dort der Raumbedarf steigt. Um jedoch ein Hörgerät nicht vergrößern zu müssen, muss die Schaltungsanordnung entsprechend kompakter gestaltet werden.

Um mehr Komponenten auf einer Hörgeräteplatine unterbringen zu können, musste bislang immer die Fläche der Platine entsprechend vergrößert werden. Eine Verbesserung der Kompaktheit der vielfach aus integrierten Schaltungen und SMD-Bauteilen zusammengesetzten Platine wurde dadurch nicht erreicht.

Aus der Patentschrift US 6 472 737 B1 ist eine Anordnung aus einem Substrat, einem darauf angeordneten Halbleiterbauelement und einem wiederum darauf montierten Leiterrahmen bekannt. Das Halbleiterbauteil ist über Bonddrähte sowohl mit dem Substrat als auch mit dem Leiterrahmen verbunden.

Aus der Druckschrift US 2006/0113677 A1 ist ein Multi-Chip-Modul bekannt. Ein Flash-Speicher wird Rücken an Rücken an einen ASIC geklebt. Weiterhin wird der Flash-Speicher durch einen Bonddraht mit einer entsprechenden Elektrode eines Montagesubstrats verbunden.

Darüber hinaus beschreibt die Druckschrift US/2003/0034563 A1 ein Verfahren zum Stapeln von Rohchips. Mit Epoxy wird ein Rohchip auf ein Substrat oder einen anderen Chip aufgeklebt. zwischen dem Substrat und den Rohchips werden elektrische Verbindungen mittels Bonddrähten hergestellt.

Die Aufgabe der vorliegenden Erfindung besteht darin, die Kompaktheit einer Platine und insbesondere einer Hörgeräteplatine zu verbessern.

Erfindungsgemäß wird diese Aufgabe gelöst durch eine Schaltungsvorrichtung **nach Anspruch 1**.

In vorteilhafter Weise ist es so möglich, SMD-Bauteile auf nahezu alle Untergründe zu montieren und auf sehr kompakte Weise zu kontaktieren. Außerdem können SMD-Bauteile eingesetzt werden, die in der Regel kleinere Abmessungen besitzen als sonstige vergleichbare Bauelemente.

**Die** Schaltungsvorrichtung **weist** einen Träger **und eine** integrierte Schaltung auf, die auf den Träger montiert ist, wobei das SMD-Bauteil auf die integrierte Schaltung montiert und durch Bonddrähte mit der integrierten Schaltung elektrisch verbunden ist. Als Träger kommt beispielsweise eine Leiterplatte (PCB), ein LTCC-Substrat und dergleichen **infrage.**

In vorteilhafter Weise kann durch das Stapeln des SMD-Bauteils oder der integrierten Schaltung auf eine weitere integrierte Schaltung auf der Leiterplatte bzw. den Träger Platz eingespart werden. Somit kann ein höherer Grad an Miniaturisierung erreicht werden. Darüber hinaus ist es von besonderem Vorteil, wenn die weitere bzw. eine integrierte Schaltung direkt über Bonddrähte mit dem SMD-Bauteil verbunden ist. Dadurch werden die Verbindungen kürzer und außerdem können die Verbindungen direkt gelegt werden.

Bei einer speziellen Ausführungsform kann das SMD-Bauteil unter Zwischenfügen mindestens einer weiteren integrierten Schaltung auf die integrierte Schaltung bzw. den Träger montiert werden. Durch diese Mehrfachstapelung kann entsprechend viel Platz auf dem Träger eingespart werden.

Ebenso kann zwischen die weitere integrierte Schaltung und die integrierte Schaltung mindestens eine dritte integrierte Schaltung montiert werden. Auch dies führt selbstverständlich zu einer Platzeinsparung auf einer Verstärker- bzw. Hörgeräteplatine zumindest in lateraler Richtung.

Bei den integrierten Schaltungen kann es sich gegebenenfalls um anwendungsspezifische ASICs handeln. Gerade bei ASICs besteht nämlich die Problematik, dass deren Integrationsgrad nicht so hoch ist wie bei Standard-ICs.

Die weitere integrierte Schaltung kann mit Flip-Chip-, CSP-, BGA- oder Drahtbond-Technik auf dem Träger montiert werden. Dies bedeutet, dass das Prinzip, integrierte Schaltungen und/oder SMD-Bauteile miteinander zu stapeln und über Bonddrähte zu verbinden, auf alle möglichen Arten von integrierten Schaltungen angewandt werden kann.

Das SMD-Bauteil **weist** einen Piezo-Kristall **auf**. Hierbei ergibt sich der weitere Vorteil, dass die Schwingungen des Piezo-Kristalls nicht direkt über die Leiterplatte zu einem schwingungsempfindlichen anderen Bauteil übertragen werden, wenn das SMD-Kristall auf einem anderen Bauteil montiert ist. Es findet auch dann keine direkte Übertragung der Schwingungen statt, wenn der SMD-Kristall auf dem Träger und ein schwingungsempfindliches Bauteil auf einer integrierten Schaltung montiert sind.

Entsprechend einer weiteren Ausführungsform ist das SMD-Bauteil durch einen der Bonddrähte mit einem Bond-Pad auf dem Träger und von dort durch einen weiteren der Bonddrähte mit der integrierten Schaltung elektrisch verbunden. Dies kann bei sehr engen Platzverhältnissen auf der integrierten Schaltung bzw. dem SMD-Bauteil von Vorteil sein.

Wie oben bereits angedeutet wurde, lässt sich eine erfindungsgemäße Schaltungsvorrichtung besonders vorteilhaft in einem Hörgerät einsetzen. Dabei kann zum einen die erhöhte Miniaturisierung ausgenutzt werden und zum anderen von einer verminderten Schwingungsübertragung durch die Stapeltechnik und die Bond-Verbindungstechnik profitiert werden.

Die vorliegende Erfindung ist anhand der beigefügten Zeichnungen näher erläutert, in denen zeigen:
- FIG 1: den prinzipiellen Aufbau eines Hörgeräts gemäß dem Stand der Technik;
- FIG 2: eine Anordnung von Schaltungselementen gemäß einer ersten Ausführungsform der vorliegenden Erfindung;
- FIG 3: eine nicht **beanspruchte** Anordnung von **Schaltungs- elementen**;
- FIG 4: eine Seitenansicht einer Anordnung von Schaltungs- elementen gemäß einer **zweiten** Ausführungsform der vorliegenden Erfindung; und
- FIG 5: eine Draufsicht auf die Schaltungsanordnung von FIG 4.

Die nachfolgend näher geschilderten Ausführungsbeispiele stellen bevorzugte Ausführungsformen der vorliegenden Erfindung dar.

Die in FIG 2 beispielhaft dargestellte Schaltungsvorrichtung besteht aus einer Leiterplatte bzw. einem PCB-Substrat 10 als Träger, auf das ein erster ASIC 11 aufgebracht ist. Dies kann durch eine beliebige Chip-Montagetechnik wie beispielsweise Flip-Chip-Technik, Draht-Bond-Technik, CSP-Technik (Chip Scale Package), BGA-Technik (Ball Grid Array) etc. erfolgen. In

FIG 2 ist der erste Montageschritt zur elektrischen und/oder mechanischen Verbindung des ersten ASIC 11 mit dem PCB-Substrat durch M1 gekennzeichnet. Auf den ersten ASIC 11 ist ein zweiter ASIC 12 mit wiederum einer beliebigen Montagetechnik montiert. Dieser zweite Montageschritt ist in FIG 2 mit M2 gekennzeichnet.

Direkt auf das zweite ASIC 12 ist ein SMD-Kristall 13 montiert, der auf dem piezoelektrischen Prinzip basiert und eine Oszillationsfrequenz bzw. Taktfrequenz bereitstellt. Die Befestigung des SMD-Kristalls 13 auf dem zweiten ASIC 12 erfolgt wiederum nach einer beliebigen der oben genannten Verbindungstechniken (Kleben, Löten etc.). Der Verbindungsschritt ist in FIG 2 mit M3 bezeichnet.

Die elektrische Verbindung des SMD-Kristalls 13 mit dem zweiten ASIC 12 erfolgt in dem Beispiel von FIG 2 mithilfe von Bonddrähten 14. Das zweite ASIC 12 ist seinerseits mit dem PCB-Substrat 10 über Bonddrähte 15 verbunden. Selbstverständlich können auch andere elektrische Verbindungen der dargestellten Bauteile mit Bonddrähten erfolgen. Eine Kombination mit anderen Kontaktier- und Verbindungstechniken bleibt unbenommen.

Der in FIG 2 dargestellte Aufbau hat folgende Vorteile:
1. Durch das Stapeln der ASIC- und SMD-Komponenten ist ein höheres Maß an Miniaturisierung erreichbar.
2. Das Übereinanderstapeln der ASIC- und SMD-Komponenten ermöglicht es, einen Schaltungsaufbau in vertikaler Richtung besser nutzen zu können.
3. Die Draht-Bond-Technik erlaubt eine kurze und direkte Verbindung beispielsweise einer ASIC- mit einer SMD-Komponente.
4. Der erste ASIC 11 kann auf dem PCB-Substrat 10 mit beliebigen Montagetechniken wie Fip-Chip, Drahtbonden, CSP, BGA etc., montiert werden.
5. Es können beliebige Arten von Multi-Layer-Substraten als Leiterplatte verwendet werden: z. B. Multi-Layer-PCB-Substrate, Multi-Layer-Dickfilm-Substrate, Multi-Layer-LTCC-Substrate (Low Temperature co-fired Ceramic), Multi-Layer-LTCC-Substrate mit versenktem Bondraum (Cavity).
6. Durch die Übereinanderstapelung überträgt der SMD-Kristall 13 seine Schwingungen nicht direkt über das PCB-Substrat 10, sondern allenfalls gedämpft durch die dazwischen befindlichen Bauelemente und die Verbindungsstoffe wie Kleber, Metall oder Lot. Dadurch kann gerade für die Abstrahlung von höheren Frequenzen eine bessere Dämpfung erzielt werden. Die Schwingungsübertragung bzw. Körperschallübertragung über die Bonddrähte spielt praktisch keine Rolle.

FIG 3 zeigt **eine hier nicht beanspruchte** Schaltungsvorrichtung. Auf dem PCB-Substrat 20 ist hier ein erstes ASIC 21 aufgebracht. Dies erfolgt mit einem Montageschritt M4, der wie der Schritt M1 gemäß dem Beispiel von FIG 2 ausgeführt sein kann.

Auf das erste ASIC 21 ist ein zweites ASIC 22 aufgeklebt, aufgelötet oder anderweitig befestigt. Dieser Befestigungsschritt ist in FIG 3 mit M5 gekennzeichnet und kann wie der Schritt M2 in dem Beispiel von FIG 2 erfolgen.

Auf das PCB-Substrat 20 ist auch ein SMD-Kristall 23 aufgelötet oder anderweitig befestigt. Der Befestigungsschritt ist in FIG 3 mit M6 bezeichnet.

Die verdrahtung des SMD-Kristalls 23 mit dem zweiten ASIC 22 erfolgt analog dem Beispiel von FIG 2 mit Bonddrähten 24. Das zweite ASIC 22 ist seinerseits mit Bonddrähten 25 elektrisch mit dem PCB-Substrat 20 kontaktiert. Auch hier ist die Verdrahtung nur symbolisch angedeutet und kann zwischen den einzelnen Elektronikelementen auch anders erfolgen. Wesentlich ist nur, dass zwischen dem Mehr-Chip-Modul, bestehend aus den ASICs 21 und 22, und dem SMD-Bauteil 23 Bonddrahtverbindungen 24 bestehen.

Das Ausführungsbeispiel gemäß FIG 3 hat wiederum insbesondere für einen Hörgeräteverstärker die folgenden Vorteile:
1. Die Bonddrähte ermöglichen eine kurze und direkte Verbindung von einem ASIC zu der SMD-Komponente.
2. Das erste ASIC 21 kann mit einer beliebigen Montagetechnik, wie Flip-Chip, Drahtbonden, CSP, BGA etc., auf dem PCB-Substrat 20 montiert werden.
3. Es können sämtliche oben genannten Multi-Layer-Substrate verwendet werden.

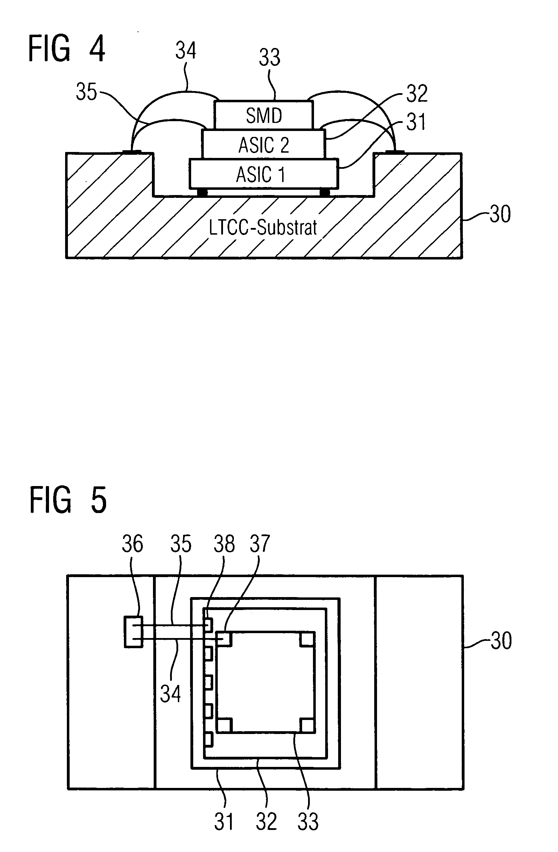

In FIG 4 ist eine **zweite** Ausführungsform einer erfindungsgemäßen Schaltungsvorrichtung in der Seitenansicht bzw. im Querschnitt dargestellt. In die Vertiefung eines LTCC-Substrats 30 ist ein erster ASIC 31 eingebracht. Darauf befindet sich wie in dem Ausführungsbeispiel von FIG 2 ein zweiter ASIC 32 und darauf wiederum das SMD-Bauteil 33. Die Anordnung ist in FIG 5 in der Draufsicht dargestellt. Das SMD-Bauteil 33 ist hier aber nicht direkt wie in dem Beispiel von FIG 2 an den zweiten ASIC 32 gebondet. Vielmehr erfolgt die Bondverbindung zwischen dem SMD-Bauteil 33 und der zweiten integrierten Schaltung bzw. dem zweiten ASIC 32 indirekt über ein Bond-Pad 36 auf dem Träger bzw. LTCC-Substrat 30. Konkret weist das SMD-Bauteil 33 einen Kontakt 37 auf, der mit dem Bond-Pad 36 auf dem LTCC-Substrat 30 mithilfe des Bonddrahts 34 verbunden ist. Weiterhin besteht eine Bonddraht-Verbindung mithilfe des Bonddrahts 35 von dem Bond-Pad 36 zu einem Bond-Konktakt 38 des zweiten ASICs 32.

## Patentansprüche

1. Schaltungsvorrichtung **insbesondere für eine Hörvorrichtung mit**
- **einem** Träger (10, 20, 30) und
- **einer integrierten** Schaltung (**12, 22, 32**), die auf den Träger (10, 20, 30) montiert **ist**,
**dadurch gekennzeichnet, dass**
- **ein** SMD-Bauteil (13, 23, 33) auf die integrierte Schaltung (12, 22, 32) montiert **ist**,
- **das** SMD-Bauteil (13, 23, 33) durch Bonddrähte (14, 24, 34) mit der integrierten Schaltung (12, 22, 32) elektrisch verbunden ist und
- **das SMD-Bauteil (13, 23, 33) einen Piezo-Kristall aufweist.**

2. Schaltungsvorrichtung nach Anspruch 1, wobei zwischen die integrierte Schaltung (12, 22, 32) und den Träger (10, 20, 30) mindestens eine weitere integrierte Schaltung (11, 21, 31) montiert ist.

3. Schaltungsvorrichtung nach **Anspruch 2**, wobei die eine und/oder die weitere integrierte Schaltung (11, 21; 12, 22; 31, 32) ein ASIC ist.

4. Schaltungsvorrichtung nach **Anspruch 2 oder 3**, wobei die weitere integrierte Schaltung (11, 21, 31) mit Flip-Chip-, CSP-, BGA- oder Drahtbond-Technik auf der Leiterplatte (10, 20) montiert ist.

5. Schaltungsvorrichtung nach einem der **vorhergehenden Ansprüche, wobei** das SMD-Bauteil (13, 23, 33) durch einen der Bonddrähte (14, 24, 34) mit einem Bond-Pad (36) auf dem Träger (10, 20, 30) und von dort durch einen weiteren der BondDrähte (14, 24, 34) mit der integrierten Schaltung (12, 22, 32) elektrisch verbunden ist.

6. Hörgerät mit einer Schaltungsvorrichtung nach einem der vorhergehenden Ansprüche.

## Claims

1. Circuit device, in particular for a hearing device, comprising
- a carrier (10, 20, 30) and
- an integrated circuit (12, 22, 32) which is mounted on the carrier (10, 20, 30),
**characterised in that**
- an SMD component (13, 23, 33) is mounted on the integrated circuit (12, 22, 32),
- the SMD component (13, 23, 33) is electrically connected to the integrated circuit (12, 22, 32) by means of bond wires (14, 24, 34) and
- the SMD component (13, 23, 33) has a piezoelectric crystal.

2. Circuit device according to claim 1, wherein at least one further integrated circuit (11, 21, 31) is mounted between the integrated circuit (12, 22, 32) and the carrier (10, 20, 30).

3. Circuit device according to claim 2, wherein the one and/or the further integrated circuit (11, 21; 12, 22; 31, 32) are/is an ASIC.

4. Circuit device according to claim 2 or 3, wherein the further integrated circuit (11, 21, 31) is mounted on the printed circuit board (10, 20) using flip-chip, CSP, BGA or wire bonding technology.

5. Circuit device according to one of the preceding claims, wherein the SMD component (13, 23, 33) is electrically connected by means of one of the bond wires (14, 24, 34) to a bond pad (36) on the carrier (10, 20, 30) and from there by means of another of the bond wires (14, 24, 34) to the integrated circuit (12, 22, 32).

6. Hearing aid having a circuit device according to one of the preceding claims.

## Revendications

1. Montage notamment pour une prothèse auditive comprenant
- un support ( 10, 20, 30 ) et
- un circuit ( 12, 22, 32) intégré qui est monté sur le support ( 10, 20, 30)
**caractérisé en ce que**
- un composant ( 13, 23, 33) SMD est monté sur le circuit ( 12, 22, 32 ) intégré,
- le composant ( 13, 23, 33) SMD est relié électriquement au circuit ( 12, 22, 32 ) intégré par des fils ( 14, 24, 34 ) de liaison et
- le composant ( 13, 23, 33 ) SMD comporte un cristal piézo-électrique.

2. Montage suivant la revendication 1, dans lequel au moins un autre circuit ( 11, 21, 31 ) intégré est monté entre le circuit ( 12, 22, 32 ) intégré et le support ( 10, 20, 30 ).

3. Montage suivant la revendication 2, dans lequel le un et/ou l'autre circuit ( 11, 21 ; 12, 22 ; 31, 32 ) intégré est un ASIC.

4. Montage suivant la revendication 2 ou 3, dans lequel l'autre circuit ( 11, 21, 31 ) intégré est monté par une technique flip-chip, CSP, BGA ou à liaison par fil sur la plaquette ( 10, 20 ) à circuit intégré.

5. Montage suivant l'une des revendications précédentes, dans lequel le composant ( 13, 23, 33 ) SMD est relié électriquement par l'un des fils ( 14, 24, 34 ) de liaison à une plage ( 36 ) de liaison sur le support ( 10, 20, 30 ) et de là, par un autre des fils ( 14, 24, 34 ) de liaison, au circuit ( 12, 22, 32 ) intégré.

6. Prothèse auditive ayant un montage suivant l'une des revendications précédentes.
